# EUROPEAN PATENT SPECIFICATION

(11) **EP 0 792 519 B1**
(45) Date of publication and mention of the grant of the patent: **26.03.2003**
(21) Application number: 95939967.6
(22) Date of filing: 13.11.1995
(51) Int. Cl.: H01R 9/00, H01R 29/00, B23K 31/02, H05K 3/30, H01L 23/49, H01L 21/60, H01L 23/48, H01L 23/498, H01L 21/66, H01L 21/68

(54) **INTERCONNECTION ELEMENTS FOR MICROELECTRONIC COMPONENTS**
VERBINDUNGSELEMENTE FÜR MIKROELEKTRONISCHE KOMPONENTEN
ELEMENTS D'INTERCONNEXION POUR COMPOSANTS MICRO-ELECTRONIQUES

(30) Priority: 15.11.1994 US 340144; 16.11.1994 WO PCT/US94/13373; 26.05.1995 US 452255; 01.06.1995 US 457479; 21.09.1995 US 526246; 18.10.1995 US 533584; 09.11.1995 US 554902
(43) Date of publication of application: 03.09.1997
(73) Proprietor: FORMFACTOR, INC., Livermore, CA 94550 (US)
(72) Inventor: KHANDROS, Igor, Y., Orinda, CA 94563 (US); MATHIEU, Gaetan, L., Dublin, CA 94568 (US)
(74) Representative: Käck, Jürgen
(86) International application number: US9514843
(87) International publication number: WO96016440

(56) References cited:
- EP-A- 0 002 166
- EP-A- 0 396 248
- EP-A- 0 500 074
- DE-A- 2 354 256
- DE-A- 3 129 568
- FR-A- 2 643 753
- FR-A- 2 680 284
- US-A- 3 373 481
- US-A- 3 460 238
- US-A- 3 509 270
- US-A- 3 616 532
- US-A- 3 795 037
- US-A- 4 067 104
- US-A- 4 295 700
- US-A- 4 330 165
- US-A- 4 418 857
- US-A- 4 532 152
- US-A- 4 642 889
- US-A- 4 667 219
- US-A- 4 705 205
- US-A- 4 764 848
- US-A- 4 777 564
- US-A- 4 793 814
- US-A- 4 821 148
- US-A- 4 860 433
- US-A- 4 893 172
- US-A- 4 914 814
- US-A- 4 955 523
- US-A- 4 989 069
- US-A- 5 067 007
- US-A- 5 086 337
- US-A- 5 095 187
- US-A- 5 110 032
- US-A- 5 130 779
- US-A- 5 189 507
- US-A- 5 195 237
- US-A- 5 299 939
- US-A- 5 317 479
- US-A- 5 366 380
- US-A- 5 386 344
- US-A- 5 476 211
- "Bimetal VLSI Chip Interconnections" IBM TECHNICAL DISCLOSURE BULLETIN, vol. 29, no. 11, April 1987, NEW YORK US, pages 5021-5022, XP002040446
- PATENT ABSTRACTS OF JAPAN vol. 011, no. 148 (E-506), 14 May 1987 & JP 61 287254 A (HITACHI DEVICE ENG CO LTD;OTHERS: 01), 17 December 1986,
- PATENT ABSTRACTS OF JAPAN vol. 009, no. 075 (E-306), 4 April 1985 & JP 59 211253 A (MATSUSHITA DENSHI KOGYO KK), 30 November 1984,
- PATENT ABSTRACTS OF JAPAN vol. 011, no. 092 (E-491), 24 March 1987 & JP 61 244057 A (NGK SPARK PLUG CO LTD), 30 October 1986,
- PATENT ABSTRACTS OF JAPAN vol. 010, no. 293 (E-443), 4 October 1986 & JP 61 112357 A (NEC CORP), 30 May 1986,
- SHIH D -Y ET AL: "A NOVEL ELASTOMERIC CONNECTOR FOR PACKAGING INTERCONNECTIONS, TESTING AND BURN-IN APPLICATIONS" 21 May 1995 , PROCEEDINGS OF THE ELECTRONIC COMPONENTS AND TECHNOLOGY CONFERENCE, LAS VEGAS, MAY 21 - 24, 1995, NR. CONF. 45, PAGE(S) 126 - 133 , INSTITUTE OF ELECTRICAL AND ELECTRONICS ENGINEERS XP000624964 * the whole document *

## Description

The invention relates to making an interposer for interconnections between electronic components, especially microelectronic components and, more particularly, to interconnection elements made from forming a sheet of material, then overcoating to make resilient interconnection elements.

Electronic components, particularly microelectronic components such as semiconductor devices (chips), often have a plurality of terminals (also referred to as bond pads, electrodes, or conductive areas). In order to assemble such devices into a useful system (or subsystem), a number of individual devices must be electrically interconnected with one another, typically through the intermediary of a printed circuit (or wiring) board (PCB, PWB).

Generally, as used herein, an "interposer" is a substrate having contacts on two opposite surfaces thereof, disposed between two electronic components to interconnect the two electronic components. Often, it is desirable that the interposer permit at least one of the two interconnected electronic components to be removed (e.g., for replacement, upgrading, and the like).

Generally, interconnections between electronic components can be classified into the two broad categories of "relatively permanent" and "readily demountable".

An example of a "relatively permanent" connection is a solder joint. Once two components are soldered to one another, a process of unsoldering must be used to separate the components. A wire bond is another example of a "relatively permanent" connection.

An example of a "readily demountable" connection is rigid pins of one electronic component being received by resilient socket elements of another electronic component. The socket elements exert a contact force (pressure) on the pins in an amount sufficient to ensure a reliable electrical connection therebetween. Interconnection elements intended to make pressure contact with an electronic component are referred to herein as "springs" or "spring elements".

Spring elements are well known, and appear in a variety of shapes and sizes. In today's microelectronic environment, there is a profound need for all interconnection elements, including springs, to become smaller and smaller, in order that a large plurality of such interconnection elements can be disposed in a small area, to effect a high density of interconnections to electronic components.

Prior art techniques for making spring elements generally involve stamping (punching) or etching a spring material, such as phosphor bronze or beryllium copper or steel or a nickel-iron-cobalt (e.g., kovar) alloy, to form individual spring elements, shaping the spring elements to have a spring shape (e.g., arcuate, etc.), plating the spring elements with a good contact material (e.g., a noble metal such as gold, which will exhibit low contact resistance when contacting a like material), and molding a plurality of such shaped, plated spring elements into a linear, a peripheral or an array pattern. When plating gold onto the aforementioned materials, sometimes a thin, for example, 30-50 microinches (where 1 microinch = 0.0254 µm), barrier layer of nickel is appropriate.

Various problems and limitations are inherent with such techniques of making spring elements.

For example, these processes are limited when applications demand that a plurality of springs (interconnection elements) be arranged at a fine (e.g., 10 mil where 1 mil = 25.4 µm) pitch. Such a fine pitch inherently demands that each spring be sized (i.e., in cross-section) substantially smaller (e.g., 3 mil) than the pitch. A punch-out area must be accommodated, and will limit how much material is left over to form springs. At best, even though it may be relatively straightforward to punch out springs as small as 1 mil, such small sizes impose limitations on the contact force that can reliably be exerted by the springs. This is especially poignant in the context of fabricating area arrays of springs.

Generally, a certain minimum contact force is desired to effect reliable pressure contact to electronic components (e.g., to terminals on electronic components). For example, a contact (load) force of approximately 15 grams (including as little as 2 grams or less and as much as 150 grams or more, per contact) may be desired to ensure that a reliable electrical connection is made to a terminal of an electronic component which may be contaminated with films on its surface, or which has corrosion or oxidation products on its surface. The minimum contact force required of each spring demands either that the yield strength of the spring material or that the size of the spring element are increased. As a general proposition, the higher the yield strength of a material, the more difficult it will be to work with (e.g., punch, bend, etc.). And the desire to make springs smaller essentially rules out making them larger in crcss-section.

Another limitation attendant prior art interconnection elements is that when hard materials (such as would be used for making springs) are employed, relatively "hostile" (e.g., high temperature) processes such as brazing are required to mount the interconnection elements to terminals of an electronic component. For example, it is known to braze rigid pins to relatively "durable" semiconductor packages. Such "hostile" processes are generally not desirable (and often not feasible) in the context of certain relatively "fragile" electronic components such as semiconductor devices. In contrast thereto, wire bonding is an example of a relatively "friendly" processes that is much less potentially damaging to fragile electronic components than brazing. Soldering is another example of a relatively "friendly" process.

Another problem associated with mounting springs on electronic components is largely mechanical in nature. In cases where a spring is mounted at one end to a substrate (which, for purposes of this proposition is considered to be an immovable object), and is required to react forces applied at its free end, the "weak link" (weakest point, in service) will often be the point at which the spring is attached (e.g., the base of the spring is bonded) to the substrate (e.g., terminal of an electronic component). This accounts, at least in part, for the requirement to employ "hostile" processes (e.g., brazing) to mount the springs to the substrate.

Another subtle problem associated with interconnection elements, including spring contacts, is that, often, the terminals of an electronic component are not perfectly coplanar. Interconnection elements lacking in some mechanism incorporated therewith for accommodating these "tolerances" (gross non-planarities) will be hard pressed to make consistent contact pressure contact with the terminals of the electronic component.

DE-A-23 54 256 discloses a semiconductor wire bonding method, in which, upon bonding, the wire is mechanically reinforced by depositing a suitable material.

FR-A-2 680 284 discloses an interconnection device which can realize connections with very small pitch. An interconnection element comprises a plurality of conductors arranged in parallel. Both ends of each conductor are wired to the surface of a substrate such that each conductor forms a half-loop. The electrical contact between the interconnection element and the circuit to be interconnected is made by an elastic contact between the conductors of the interconnection element and the contact pads of the circuit.

DE-A-31 29 568, which represents the closest prior art, discloses an interconnection system in which a terminal of a semiconductor device is connected to a terminal of a substrate through an elastic interconnection element by soldering. The elastic element can absorb stress produced between the terminal of the semiconductor device and the terminal of the substrate.

EP-A-0 396 248 discloses an electrical pin comprising an electrically-conductive pin member and electrically-conductive head members at both end surfaces of the pin member. These miniature pins are particularly suited for directly connecting chip devices and package substrates.

US-A-5 299 939 discloses a spring array connector having a first array spring connector and a second array spring connector. Each connector comprises a plurality of springs covered with an overall electrical layer.

US-A-5 317 479 discloses a curved lead which provides mechanical and electrical connection between a chip contact and a circuit board, wherein the curved lead is formed from a single strip of metallic conductive material and is substantially entirely plated with solder. The curved lead is generally S-shaped or Z-shaped, and has first and second parallel contact surfaces arranged to mount the chip contact to the circuit board with the solder, in a compliant and generally parallel arrangement, substantially free of stress.

The following U.S. Patents are cited as being of interest: 5,386,344; 5,336,380; 5,317,479; 5,086,337; 5,067,007; 4,989,069; 4,893,172; 4,793,814; 4,777,564; 4,764,848; 4,667,219; 4,642,889; 4,330,165; 4,295,700; 4,067,104; 3,795,037; 3,616,532; and 3,509,270.

The invention is defined in claim 1. Particular embodiments of the invention are set out in the dependent claims 2 to 14.

As used in this application, the term "spring shape" refers to virtually any shape of an elongate element which will exhibit elastic (restorative) movement of an end (tip) of the elongate element with respect to a force applied to the tip. This includes elongate elements shaped to have one or more bends, as well as substantially straight elongate elements.

The tabs are shaped prior to mounting to an electronic component.

In the invention, the tabs are of a "soft" material having a relatively low yield strength, and are overcoated with a "hard" material having a relatively high yield strength. For example, a soft material such as a gold is overcoated (e.g., by electrochemical plating) with a hard material such as nickel and its alloys.

Generally, throughout the description set forth herein, the term "plating" is used as exemplary of a number of techniques for overcoating the tabs. It is within the scope of this invention that the tabs can be overccated by any suitable technique including, but not limited to: various processes involving deposition of materials out of aqueous solutions; electrolytic plating; electroless plating; chemical vapor deposition (CVD); physical vapor deposition (PVD); processes causing the disintegration of liquids, solids or gases; and the like, all of these techniques for depositing materials being generally well known.

Generally, for overcoating the tabs with a metallic material such as nickel, electrochemical processes are preferred, especially electroless plating.

Soft materials, such as gold, which attach easily to semiconductor devices, generally lack sufficient resiliency to function as springs. (Such soft, metallic materials exhibit primarily plastic, rather than elastic deformation.) Other soft materials which may attach easily to semiconductor devices and possess appropriate resiliency but which are not in accordance with the present invention are often electrically non-conductive, as in the case of most elastomeric materials. In either case, desired structural and electrical characteristics can be imparted to the resulting composite interconnection element by the overccating applied over the core. The resulting composite interconnection element can be made very small, yet can exhibit appropriate contact forces. Moreover, a plurality of such composite interconnection elements can be arranged at a fine pitch (e.g., 10 mils), even though they have a length (e.g., 100 mils) which is much greater than the pitch.

Other objects, features and advantages of the invention will become apparent in light of the following description thereof.

Reference will now be made in detail to preferred embodiments of the invention, examples of which are illustrated in the accompanying drawings. Although the invention will be described in the context of these preferred embodiments, it should be understood that it is not intended to limit the scope of the invention to these particular embodiments.
**Figure 1A** is a top plan view of a soft metal foil, in a preliminary step of making an interposer, according to the invention.
**Figure 1B** is a cross-sectional view of the soft metal foil cf **Figure 1A,** in a subsequent process step, according to the invention.
**Figure 1C** is a perspective view of the soft metal foil cf **Figure 1A,** in a subsequent process step, according to the invention.
**Figure 1D** is a perspective view of the soft metal foil cf **Figure 1A,** in a subsequent process step, in use as an interposer between two electronic components, according to the invention.
**Figure 2A** is a top plan view of a soft metal foil, in a preliminary step of making an interposer, according to an alternate embodiment of the invention.
**Figure 2B** is a perspective view of the soft metal foil cf **Figure 2A,** in a subsequent process step, according to the invention.
**Figure 2C** is a perspective view of the soft metal foil cf **Figure 2A,** in a subsequent process step, according to the invention.
**Figure 2D** is a perspective view of the soft metal foil cf **Figure 2A,** in a subsequent process step, in use as an interposer between two electronic components, according to the invention.
**Figure 3A** is a top plan view of a soft metal foil, in a preliminary step of making an interposer, according to an alternate embodiment of the invention.
**Figure 3B** is a perspective view of the soft metal foil cf **Figure 3A,** in a subsequent process step, according to the invention.
**Figure 3C** is a perspective view of the soft metal foil cf **Figure 3A,** in a subsequent process step, according to the invention.
**Figure 3D** is a perspective view of the soft metal foil cf **Figure 3A,** in a subsequent process step, in use as an interposer between two electronic components, according to the invention.
**Figure 4A** is a cross-sectional view of a technique which is particularly well suited to making individual interconnection elements.
**Figure 4B** is a cross-sectional view of another technique which is particularly well suited to making individual interconnection elements.

The disclosure of U.S. Patent 5 476 211 is useful background for the present invention.

An important aspect of the present invention is that a composite interconnection element can be formed by starting with a first material, then overcoating the first material with an appropriate second material to establish the mechanical properties of the resulting composite interconnection element. In this manner, a resilient interconnection element (spring element) can be fabricated, starting with a core of a soft material which is readily shaped into a springable shape and which is readily attached to even the most fragile of electronic components. In light of prior art techniques of forming spring elements from hard materials, it is not readily apparent, and is arguably counter-intuitive, that soft materials can form the basis of spring elements.

The subject of using the interconnection elements of the invention in interposers has been mentioned hereinabove. Generally, as used herein, an "interposer" is a substrate having contacts on two opposite surfaces thereof, disposed between two electronic components to interconnect the two electronic components. Often, it is desirable that the interposer permit at least one of the two interconnected electronic components to be removed (e.g., for replacement, upgrading, and the like).

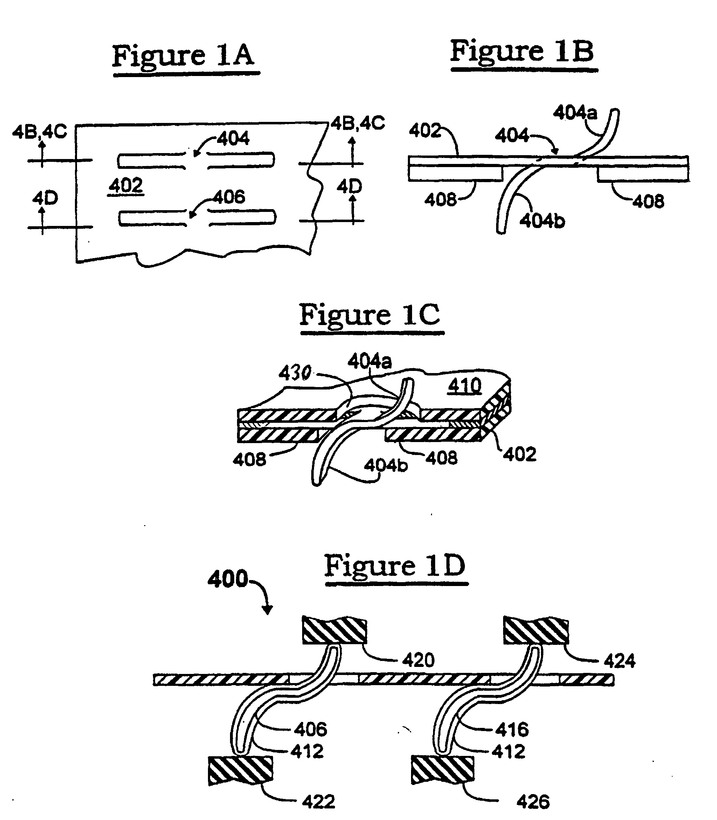

**Figures 1A, 1B, 1C and 1D** illustrates a technique for making an interposer, according to the present invention. In **Figure 1A,** it is shown that a flat, thin (such as 0.001-0.005 inches where 1 inch = 2.54 cm) sheet 402 of soft metal (e.g., gold, soft copper alloy, soft aluminum alloy) is patterned (such as by punching or etching) to define the outlines of a plurality (two of many shown) of elongate elements 404, 406 described therein. Each elongate element has a middle portion and two end portions extending in the plane of the sheet from the middle portion.

As shown in **Figure 1B,** a layer of masking material 408, such as photoresist, is applied to one surface of the soft metal sheet outside the areas of the elongate elements. The end portions of each elongate element are bent cut-of-plane with respect to the sheet. A one end portion 404a of the elongate element 404 is bent in a one direction (upward, as illustrated), thereby forming a tab extending upward from the sheet 402. The other end portion 404b of the elongate element is bent in an opposite (downward, as illustrated) direction, thereby forming a tab extending downward from the sheet 402. The tabs (404a, 404b) may extend to virtually any desired distance from the sheet, for example 5-100 mils for microelectronic applications. The shapes of these tabs (404a, 404b) can independently be controlled in the bending process, so that the upward-extending tabs have the same or a different shape than the downward-extending tabs.

It should be understood that the tabs can be formed in the same step as the patterning of the elongate elements, and these steps can be performed with conventional equipment.

As illustrated in **Figure 1C,** an insulating (dielectric) support layer 410, such as a sheet (film, plate) of Kapton (tm) or polyimide, is provided with a plurality of holes 430. The insulating sheet 410 is placed over the soft metal sheet 402 so that the holes 430 align with the tabs, on a side of the sheet opposite the masking material, and is secured to the soft metal sheet with a suitable adhesive (not shown).

It is within the scope of this invention that the insulating sheet, both in this embodiment and embodiments described hereinbelow, can be a metal plate covered with a dielectric material.

The entire assembly is then overcoated with a hard material 412, such as nickel and its alloys. The support sheet 410 and the masking material 408 ensure that only the elongate elements are overcoated with the hard material. Finally, the masking material 408 is stripped away, and the soft metal that has not been overcoated is removed, such as by selective chemical etching. Optionally, in a post-finishing step, the interconnection elements can be overcoated (e.g., plated) with a material exhibiting good contact resistivity characteristics, such as gold.

This results in an interconnection structure having composite interconnection elements (the overcoated tabs) extending from the top and bottom surfaces thereof, as shown in **Figure 1D,** each one of the upward-extending composite interconnection elements functioning as a cantilever, and being connected by the foil (402) to a corresponding one of the downward-extending tabs which also function as a cantilever, each of the composite interconnection elements being capable of imparting a desired contact force (e.g., 15 grams) to a respective terminal of an electronic component.

In this manner, an interposer 400 is obtained, having two ends for connecting a terminal 420 of a first electronic component (not shown) to a corresponding terminal 422 of a second electronic component (not shown), and a second interconnection structure suitable for use in an interposer is obtained, having two ends for connecting a terminal 424 of the first electronic component (not shown) to a corresponding terminal 426 of the second electronic component (not shown).

**Figure 1D** illustrates an interconnection structure 400 which is formed from an elongate element 416, overccated by the same material 412, in the manner of forming the aforementioned interconnection structures. The elongate element 416 is aligned longitudinally with and at a distance from the elongate element 406, and the elongate element 416 is aligned laterally with and at a distance from the elongate element 406, demonstrating that the interconnection elements can be disposed in arrays.

An advantage of this and, as will be evident, subsequently-described techniques, is that a soft, non-resilient metal sheet, which is easily formed (punched and shaped) can be overcoated to exhibit robust resilient characteristics, in a manner similar to a soft wire core being shaped and overcoated to exhibit resiliency.

It is within the scope of this invention that a fixture may perform the function of the masking material 408, during the overcoating (e.g., plating) process, making the masking material unnecessary.

It is within the scope of this invention that a plurality of interconnection elements can be formed as individual contact structures, subsequently to be supported in proximity to one another, such as with a support sheet.

Generally, the support layer (410) supports a plurality of interconnection elements in a prescribed relationship to one another, such as in a rectangular (x,y) array pattern. The support layer can be flexible, as described hereinabove, or can be rigid (e.g., such as made cf ceramic). A flexible support layer has the advantage of allowing the supported interconnection elements to "float", within a certain range of vertical positions, to accommodate surface variations (tolerances) in electronic components being connected to.

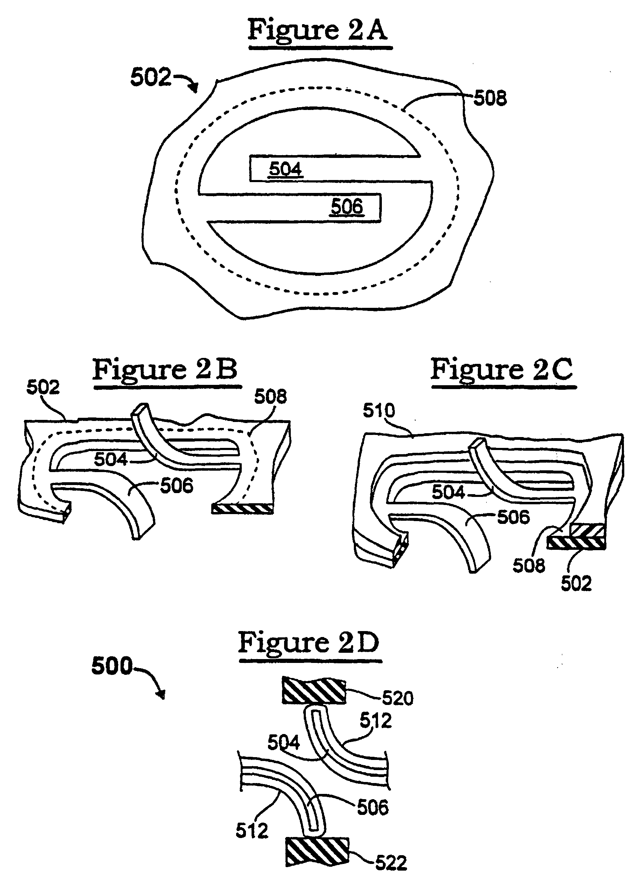

**Figures 2A-2F** illustrate an alternate technique for making an interposer from a flat sheet of metal.

As shown in **Figure 2A,** a flat sheet of soft metal (e.g., copper) sheet (e.g., foil) is patterned (punched, etched, or the like) to have two, diametrically opposed elongate elements 504 and 506, which are generally next to and parallel to one another. The elongate elements 502 and 504 are held at their base ends by a ring 508.

In a manner similar to the embodiment of **Figures 1A-1D,** a one of the elongate elements 504 is bent to be a tab extending in one direction, and another of the elongate elements 506 is bent as a tab extending in an opposite direction, resulting in the configuration shown in **Figure 2B** (compare **Figure 1B**).

As shown in **Figure 2C,** a suitable masking material 510 such as photoresist is applied to the sheet 502, outside the area of the ring 506 and the elongate elements 504 and 506.

The sheet 502 is then overcoated (e.g., plated) with a hard metallic material (e.g., nickel or its alloys) 512, thereby transforming the tabs (shaped elongate elements 504 and 506) into interconnection elements functioning as springs. Next, the masking material 510 is removed, and all non-overcoated (by 512) soft metal (502) is removed, such as by selective etching, resulting in the interposer structure 500 of **Figure 2D,** having composite interconnection elements pointing up and corresponding composite interconnection elements pointing down, both the upward and downward pointing interconnection elements functioning as cantilevers, each capable of imparting a desired contact force (e.g., 15 grams) to a respective terminal of an electronic component.

In this manner, an interposer 500 is obtained, having two ends for connecting a terminal 520 of a first electronic component (not shown) to a corresponding terminal 522 of a second electronic component (not shown).

As a general proposition, the embodiment 400 of **Figures 1A-1D** is preferred over the embodiment 500 of **Figures 2A-2D.**

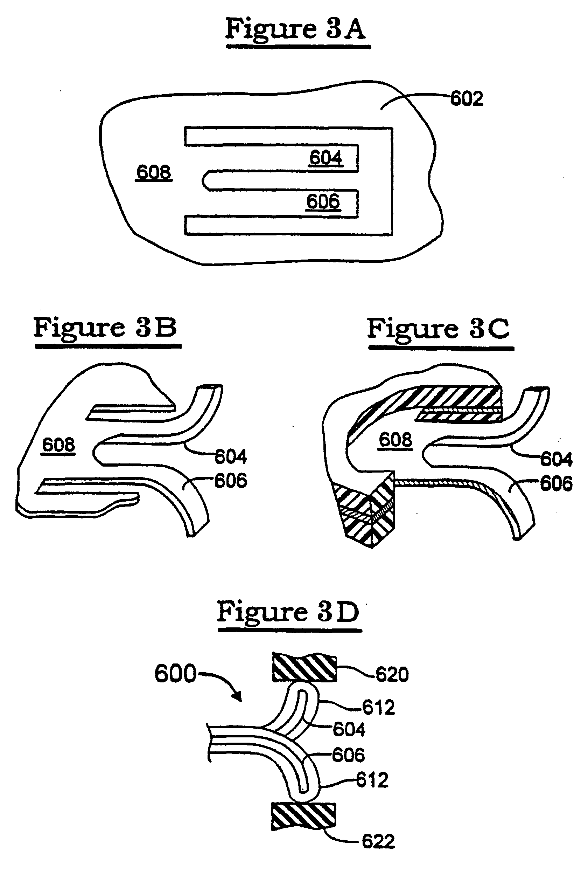

As shown in **Figures 3A-3D,** a similar (e.g., to the embodiment previously described with respect to **Figures** **2A-2E)** can be obtained by patterning a soft metal foil 602 to have two, parallel (side-by-side) elongate elements 604 and 606, which share a common base portion 608.

A one of the elongate elements 604 is bent to be a tab extending in one direction, and another of the elongate elements 606 is bent to be a tab extending in an opposite direction, resulting in the configuration shown in **Figure 3B** (compare **Figure 2B**).

As shown in **Figure 3C,** a suitable masking material such as photoresist 610 is applied to the sheet 602, outside the area of the elongate elements 604 and 606 and their common base 608.

The sheet 602 is then overcoated (e.g., plated) with a hard metallic material (e.g., nickel or its alloys) 612, thereby transforming the tabs (shaped elongate elements 604 and 606) into interconnection elements functioning as springs. Next, the masking material 610 is removed, and all non-overcoated (by 612) soft metal (602) is removed, such as by selective etching, resulting in the interposer structure 600 of **Figure 3D,** having composite interconnection elements pointing up and corresponding composite interconnection elements pointing down, both the upward and downward pointing composite interconnection elements functioning as cantilevers, each capable of imparting a desired contact force (e.g., 15 grams) to a respective terminal of an electronic component.

In this manner, an interposer 600, is obtained, having two ends for connecting a terminal 620 of a first electronic component (not shown) to a corresponding terminal 622 of a second electronic component (not shown).

Although not shown, it within the scope of this invention that a plurality of interconnection elements can be located in a desired pattern (e.g., a rectangular array) by securing them to a suitable support member such as a sheet provided with a plurality of holes, as shown in **Figure 1C.**

With reference, for example, to the embodiment 400 of **Figures 1A-1D,** it is evident that the original (prior to bending) length of the elongate elements (404, 406) establish a limit to how far the tabs can extend from the sheet - in other words, a limitation on the length (and/or height) of the resulting interconnection element.

As used herein, the term "length" generally refers to the longitudinal dimension of an elongate element prior to shaping (if any), and the term "height" generally refers to the longitudinal dimension of the elongate element (and resulting interconnection element) after shaping and coating. For purposes of the discussion set forth in this document, these terms are generally interchangeable.

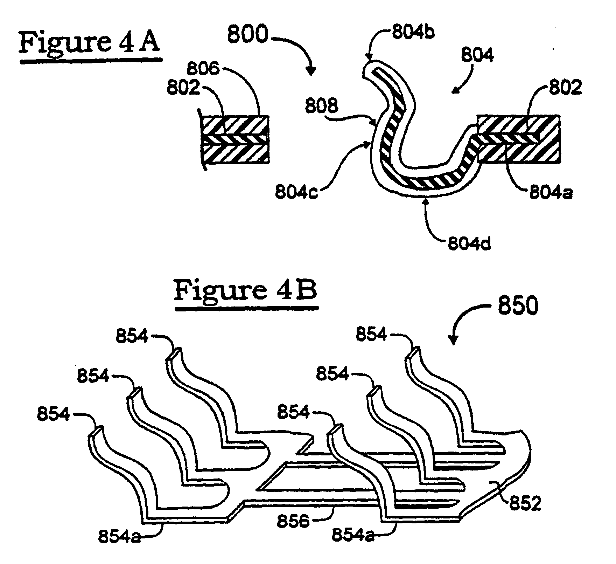

**Figures 4A and 4B** are illustrative of techniques for making individual interconnection elements, such as for stockpiling a plurality of such "spring contact" elements, and later automatically assembling them to an electronic component such as a semiconductor device or a support substrate for an interposer.

**Figure 4A** illustrates a technique 800 wherein a flat sheet (foil) 802 of a material such as soft copper is punched, etched or the like to have a plurality (one of many shown) of elongate elements (tabs) 804. The elongate elements 804 are subsequently shaped to have a spring shape. Each elongate element 804 has a base portion 804a which is essentially a vestigial (residual) portion of the sheet 802 and which preferably is allowed to remain coplanar with the sheet 802. Each elongate element 804 has an end (tip) 804b at an opposite end of the elongate element 804 from the base portion 804a. The elongate element 804 is bent to have any suitable springable shape in a region 804c which is located between the tip 804b and a portion 804d adjacent the base portion 804a.

Suitable masking material 806, such as photoresist, is applied onto both sides of the sheet 802, including (as shown) optionally over the base portion 804a of the elongate element 804, leaving the "operative" portion of the elongate element 804 unmasked. The elongate element is then overcoated with a suitable material 808, selected for its ability to impart resilience to the resulting interconnection element, as described hereinabove. The overccat material may optionally cover the base portion 804a cf the elongate element 804.

The masking material 806 is then removed, such as by selective etching. This results in a plurality of individual composite interconnection elements which can be mounted to an electronic component, or supported in a prescribed spatial relationship (e.g., an array) with one another by affixing their base portions (804a) to a support substrate. Alternatively, a plurality of interconnection elements formed according to this technique can be suspended in an array by an elastomer.

**Figure 4B** illustrates another technique 850 wherein a flat sheet (foil) 852 of a material such as soft copper is punched, etched or the like to have a plurality (six of many shown) of elongate elements (tabs) 854. Each tab 854a which is comparable to the base portion 804a in the previous embodiment 800. In this embodiment 850, the sheet is punched so that the base portions 854a are all interconnected with one another. The illustrated "bridges" 856 are merely exemplary. The elongate elements may be shaped during or subsequent to punching the sheet.
The elongate elements 854 are shaped to have a spring shape, then are overcoated with a suitable material (not shown), as described hereinabove. The overcoating (not shown, described hereinabove) is preferably applied while the elongate elements are still interconnected with one another, and it is not necessary that any masking material be applied.

In a final step, the sheet comprising the plurality of interconnected, overcoated elongate elements is further punched, to singulate (separate) the individual overcoated elongate elements (interconnection elements) from one another.

As in the previous example 800, this technique 850 results in a plurality of individual composite interconnection elements which can be mounted to an electronic component, or supported in an array with one another by affixing their base portions to a support substrate. Alternatively, a plurality of interconnection elements formed according to this technique can be suspended in an array by an elastomer.

Although the invention has been illustrated and described in detail in the drawings and foregoing description, the same is to be considered as illustrative and nct restrictive in character - it being understood that cnly preferred embodiments have been shown and described.

## Claims

1. A method of making an interposer interconnecting first and second electronic components, **characterized by**:
forming a first tab (404a; 504; 604) and a second tab (404b; 506; 606) in a sheet (402; 502; 602) of a first metallic material;
bending the tabs (404a, 404b; 504, 506; 604, 606) so that said first tab (404a; 504; 604) extends in a first direction from the sheet (402; 502; 602), and so that said second tab (404b; 506; 606) extends in a second direction from the sheet, the second direction opposite the first direction; and
subsequently overcoating the tabs with a second metallic material (412; 512; 612) which has a higher yield strength than the first material, the second material imparting resiliency to the tabs.

2. The method according to claim 1, wherein: prior to bending the tabs (404a, 404b), the first tab (404a) is longitudinally in line with the second tab (404b).

3. The method according to claim 1, wherein: prior to bending the tabs (504, 506), the first tab (504) is parallel to the second tab (506).

4. The method according to claim 1, wherein: prior to bending the tabs (604, 606), the first tab (604) is parallel to the second tab (606), and the tabs share a common base portion (608).

5. The method according to claim 1, wherein the tabs (404a, 404b; 504, 506; 604, 606) are bent so that contact regions thereof are remote from a remainder of the sheet (402; 502; 602).

6. The method according to claim 1, further comprising:
masking a portion of the sheet (402; 502; 602) with a masking layer (408; 510; 610), wherein the tabs (404a, 404b; 504, 506; 604, 606) are selectively overcoated by said second material, with the masking layer preventing overcoating of said masked portion of the sheet.

7. The method according to claim 1, wherein the sheet of first material is between 0.001 and 0.005 inches thick i.e. between 25.4 and 127 microns thick.

8. The method according to claim 1, wherein each tab (404a, 404b; 504, 506; 604, 606) extends by a distance of between 5 and 100 mils from the sheet (402; 502; 602) i.e. between 127 and 2540 microns from the sheet.

9. The method according to claim 1, wherein the first material is selected from the group consisting of gold, soft copper alloy, and soft aluminum alloy.

10. The method according to claim 1, wherein the second material includes nickel.

11. The method according to claim 1, further comprising
securing a substrate (410) to the sheet (402) of a first material such that a surface of the substrate and a surface of the sheet are parallel and adjoining,
providing a plurality of openings (430) in the substrate (410), each opening (430) accommodating a respective one of the first and second tabs (404a, 404b) allowing the respective one tab to pass through the opening so the respective one tab may extend past the surface of the substrate opposite the surface of the substrate adjoining the sheet (402).

12. The method according to claim 11, further comprising applying a masking material (408) on a surface of the sheet (402) opposite the surface of the sheet adjoining the substrate (410), patterning the masking material (408) to provide a plurality of openings, each opening accommodating a respective second one of the first and second tabs (404a, 404b) allowing the respective second tab to pass through the opening.

13. The method according to claim 12, further comprising overplating the first and second tabs (404a, 404b) with the second material such that portions of the first or second tabs in the respective openings in the substrate or openings in the masking material are overcoated.

14. The method according to claim 13, further comprising removing the portion of the sheet (402) which has not been overcoated with said second material, so the first tab and second tab (404a, 404b) are electrically connected to each other .

## Patentansprüche

1. Verfahren zur Herstellung einer Zwischenlage, die ein erstes und ein zweites elektronisches Bauteil miteinander verbindet, **gekennzeichnet durch**:
Ausbilden einer ersten Zunge (404a; 504; 604) und einer zweiten Zunge (404b; 506; 606) in einer Schicht (402; 502; 602) aus einem ersten Metallmaterial;
Biegen der Zungen (404a, 404b; 504, 506; 604, 606), so dass sich die erste Zunge (404a; 504; 604) in einer ersten Richtung von der Schicht (402; 502; 602) erstreckt und so dass sich die zweite Zunge (404b; 506; 606) in einer zweiten Richtung von der Schicht erstreckt, wobei die zweite Richtung zur ersten Richtung entgegengesetzt ist; und
anschließendes Überziehen der Zungen mit einem zweiten Metallmaterial (412; 512; 612), das eine höhere Dehngrenze aufweist als das erste Material, wobei das zweite Material den Zungen Elastizität verleiht.

2. Verfahren nach Anspruch 1, wobei: vor dem Biegen der Zungen (404a, 404b) die erste Zunge (404a) der Länge nach in einer Linie mit der zweiten Zunge (404b) liegt.

3. Verfahren nach Anspruch 1, wobei: vor dem Biegen der Zungen (504, 506) die erste Zunge (504) zur zweiten Zunge (506) parallel ist.

4. Verfahren nach Anspruch 1, wobei: vor dem Biegen der Zungen (604, 606) die erste Zunge (604) zur zweiten Zunge (606) parallel ist und die Zungen sich einen gemeinsamen Basisteil (608) teilen.

5. Verfahren nach Anspruch 1, wobei die Zungen (404a, 404b; 504, 506; 604, 606) so gebogen werden, dass deren Kontaktbereiche von einem Rest der Schicht (402; 502; 602) entfernt sind.

6. Verfahren nach Anspruch 1, welches ferner umfasst:
Maskieren eines Teils der Schicht (402; 502; 602) mit einer Maskierungsschicht (408; 510; 610), wobei die Zungen (404a, 404b; 504, 506; 604, 606) selektiv mit dem zweiten Material überzogen werden, wobei die Maskierungsschicht ein Überziehen des maskierten Teils der Schicht verhindert.

7. Verfahren nach Anspruch 1, wobei die Schicht aus dem ersten Material zwischen 0,001 und 0,005 Inch, d.h. zwischen 25,4 und 127 Mikrometer dick ist.

8. Verfahren nach Anspruch 1, wobei jede Zunge (404a, 404b; 504, 506; 604, 606) sich um einen Abstand zwischen 5 und 100 mils von der Schicht (402; 502; 602), d.h. zwischen 127 und 2540 Mikrometer von der Schicht erstreckt.

9. Verfahren nach Anspruch 1, wobei das erste Material aus der Gruppe ausgewählt ist, die aus Gold, weicher Kupferlegierung und weicher Aluminiumlegierung besteht.

10. Verfahren nach Anspruch 1, wobei das zweite Material Nickel umfasst.

11. Verfahren nach Anspruch 1, welches ferner umfasst
Befestigen eines Substrats (410) an der Schicht (402) aus einem ersten Material, so dass eine Oberfläche des Substrats und eine Oberfläche der Schicht parallel sind und aneinandergrenzen,
Vorsehen einer Vielzahl von Öffnungen (430) im Substrat (410), wobei jede Öffnung (430) eine jeweilige der ersten und der zweiten Zunge (404a, 404b) aufnimmt, was ermöglicht, dass die jeweilige eine Zunge durch die Öffnung hindurchtritt, so dass sich die jeweilige eine Zunge an der Oberfläche des Substrats entgegengesetzt zur Oberfläche des Substrats, die an die Schicht (402) angrenzt, vorbei erstrecken kann.

12. Verfahren nach Anspruch 11, ferner umfassend das Aufbringen eines Maskierungsmaterials (408) auf eine Oberfläche der Schicht (402) entgegengesetzt zur Oberfläche der Schicht, die an das Substrat (410) angrenzt, und das Strukturieren des Maskierungsmaterials (408), um eine Vielzahl von Öffnungen vorzusehen, wobei jede Öffnung eine jeweilige zweite der ersten und der zweiten Zunge (404a, 404b) aufnimmt, was ermöglicht, dass die jeweilige zweite Zunge durch die Öffnung hindurchtritt.

13. Verfahren nach Anspruch 12, welches ferner das galvanische Überziehen der ersten und der zweiten Zunge (404a, 404b) mit dem zweiten Material umfasst, so dass Teile der ersten oder der zweiten Zunge in den jeweiligen Öffnungen im Substrat oder Öffnungen im Maskierungsmaterial überzogen werden.

14. Verfahren nach Anspruch 13, welches ferner das Entfernen des Teils der Schicht (402) umfasst, der nicht mit dem zweiten Material überzogen wurde, so dass die erste Zunge und die zweite Zunge (404a, 404b) elektrisch miteinander verbunden sind.

## Revendications

1. Procédé de réalisation d'un élément intermédiaire interconnectant des premier et second composants électroniques, **caractérisé par** :
la formation d'une première languette (404a ; 504 ; 604) et d'une seconde languette (404b ; 506 ; 606) dans une feuille (402 ; 502 ; 602) d'un premier matériau métallique,
la courbure des languettes (404a, 404b ; 504, 506 ; 604, 606) de manière à ce que ladite première languette (404a ; 504 ; 604) s'étende dans une première direction par rapport à la feuille (402 ; 502 ; 602) et de manière à ce que ladite seconde languette (404b ; 506 ; 606) s'étende dans une seconde direction par rapport à la feuille, la seconde direction étant opposée à la première direction, et
l'enrobage ensuite des languettes avec un second matériau métallique (412 ; 512 ; 612) qui présente une limite élastique plus élevée que le premier matériau, le second matériau communiquant une élasticité aux languettes.

2. Procédé selon la revendication 1, dans lequel : avant la courbure des languettes (404a, 404b), la première languette (404a) est aligné longitudinalement avec la seconde languette (404b).

3. Procédé selon la revendication 1, dans lequel : avant la courbure des languettes (504, 506); la première languette (504) est parallèle à la seconde languette (506).

4. Procédé selon la revendication 1, dans lequel : avant la courbure des languettes (604, 606), la première languette (604) est parallèle à la seconde languette (606), et les languettes partagent une partie de base commune (608).

5. Procédé selon la revendication 1, dans lequel les languettes (404a, 404b; 504, 506 ; 604, 606) sont courbées de manière à ce que des régions de contact de celles-ci soient éloignées du reste de la feuille (402 ; 502 ; 602).

6. Procédé selon la revendication 1, comprenant en outre :
le masquage d'une partie de la feuille (402 ; 502 ; 602) avec une couche de masquage (408 ; 510 ; 610), dans lequel les languettes (404a, 404b ; 504, 506 ; 604, 606) sont recouvertes sélectivement par ledit second matériau, la couche de masquage empêchant un revêtement de ladite partie masquée de la feuille.

7. Procédé selon la revendication 1, dans lequel la première feuille de matériau est d'une épaisseur de 0,001 à 0,005 pouce c'est-à-dire d'une épaisseur de 25,4 à 127 micromètres.

8. Procédé selon la revendication 1, dans lequel chaque languette (404a, 404b ; 504, 506 ; 604, 606) s'étend sur une distance de 5 à 100 mils par rapport à la feuille (402 ; 502 ; 602) c'est-à-dire de 127 à 2 540 micromètres par rapport à la feuille.

9. Procédé selon la revendication 1, dans lequel le premier matériau est sélectionné à partir du groupe constitué d'or, d'alliage de cuivre mou, et d'alliage d'aluminium mou.

10. Procédé selon la revendication 1, dans lequel le second matériau comprend du nickel.

11. Procédé selon la revendication 1, comprenant en outre
la fixation d'un substrat (410) sur la feuille (402) d'un premier matériau de sorte qu'une surface du substrat et une surface de la feuille soient parallèles et jointives,
le ménagement d'une pluralité d'ouvertures (430) dans le substrat (410), chaque ouverture (430) recevant une languette respective parmi les première et seconde languettes (404a, 404b) en permettant que la une languette respective passe au travers de l'ouverture de sorte que la une languette respective puisse s'étendre au-delà de la surface du substrat à l'opposé de la surface du substrat jointive avec la feuille (402).

12. Procédé selon la revendication 11, comprenant en outre l'application d'un matériau de masquage (408) sur une surface de la feuille (402) opposée à la surface de la feuille jointive avec le substrat (410), la mise en motif du matériau de masquage (408) pour ménager une pluralité d'ouvertures, chaque ouverture recevant une seconde languette respective parmi les première et seconde languettes (404a, 404b) en permettant que la seconde languette respective passe au travers de l'ouverture.

13. Procédé selon la revendication 12, comprenant en outre le plaquage des première et seconde languettes (404a, 404b) avec le second matériau de sorte que soient recouvertes des parties des première ou seconde languettes dans les ouvertures respectives du substrat ou les ouvertures du matériau de masquage.

14. Procédé selon la revendication 13, comprenant en outre l'élimination de la partie de la feuille (402) qui n'a pas été recouverte avec ledit second matériau de sorte que la première languette et la seconde languette (404a, 404b) soient reliées électriquement l'une à l'autre.
